# EUROPEAN PATENT APPLICATION

(11) **EP 4 601 421 A1**
(43) Date of publication of application: **13.08.2025**
(21) Application number: 25156563.6
(22) Date of filing: 07.02.2025
(51) Int. Cl.: H05K 1/18, H05B 6/12, H05K 1/02

(54) **PLACEMENT OF POWER SWITCHING DEVICES ON THROUGH HOLES VIA PADS**

(30) Priority: 08.02.2024 US 202418436438
(71) Applicant: Whirlpool Corporation, Benton Harbor, MI 49022 (US)
(72) Inventor: Baldo, Salvatore, c/o Whirlpool Corp., Benton Harbor, Michigan, 49022 (US); Barbati, Mario, c/o Whirlpool Corp., Benton Harbor, Michigan, 49022 (US); Gallivanoni, Andrea, c/o Whirlpool Corp., Benton Harbor, Michigan, 49022 (US)
(74) Representative: Eisenführ Speiser

(57) **Abstract**

A printed circuit board (10) includes a substrate (16) extending in first and second lateral directions (18, 20) between respective sides (22, 24) of a perimeter (26) defined between first and second faces (28, 30). A DC bus capacitor (32) is electrically connected to a DC BUS (31) and is mounted on the first face (28) of the substrate (16). At least one resonant load capacitor (34) is mounted on the first face (28) of the substrate (16). At least one surface mount transistor (36) is mounted on the second face (30) of the substrate (16) and electrically connected with the DC bus capacitor (32) and the resonant load capacitor (34) through the substrate (16).

## Description

### BACKGROUND OF THE DISCLOSURE

The present disclosure generally relates to electronic packaging for components in an inverter useable in connection with an induction cooktop, and more specifically, to an arrangement for cooling a surface-mount transistor included therein.

The present disclosure relates to the use of various surface mount devices ("SMDs") as power switching devices, particularly in connection with an inverter, such as those used to power coils in induction cooktops, and the assembly of the same. A key aspect in the production of a power converter concerns the choice of power switching devices and managing their thermal dissipation. In particular, the same device encapsulated in different packages will have different limitations on the maximum voltage and maximum current that it will be able to handle, the maximum power it will be able to deliver, and the maximum heat generation it will be able to withstand. In various aspects, the choice of the specific type of device, such as between a metal-oxide-semiconductor field-effect transistor ("MOSFET") or insulated-gate bipolar transistor ("IGBT"), or the manner in which the device is mounted, such as between through-hole technology ("THT") or SMD packages, depends on the application.

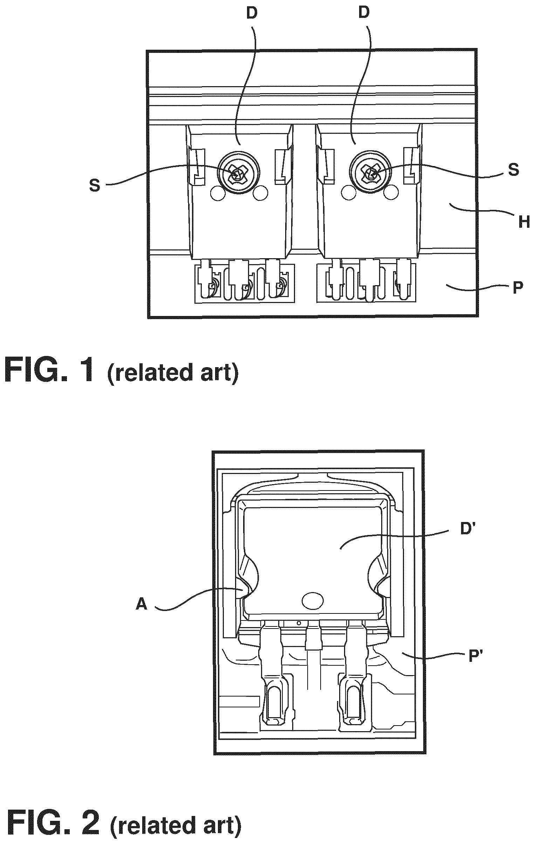

Due to the power and working frequencies involved, IGBTs with a packaging arrangement, known in the industry as a TO247 package (which, notably, is a THT mount device), are typically used in the field of inverters for induction cooking. With these packages it is possible to work up to voltages of 1500V and currents of the order of 40A, making them suitable for the production of quasi-resonant inverters and resonant half bridge inverters, the general structures of which are understood in the art. In the voltage and current conditions described above, it is possible to deliver up to 3.6kW to a compatible cooking article using suitable coils (including those with a diameter on the order of 210 mm or more). If, on the other hand, the inverter is a resonant full bridge inverter, the maximum voltage and current to which each device is subjected will vary. In particular, for the same power supplied with a half bridge (e.g., 3.6kW as specified in the above example), the working current of the switching devices is halved, because with respect to a half bridge inverter the voltage across the load is double. Typically, inside an induction cooktop there are one or more inverters which allow the driving of one or more coils. Thanks to a highfrequency alternating voltage, the coils generate a variable electromagnetic field that produces heat within a cooking article operably coupled with the coil. In the induction cooking field, quasi-resonant or half bridge resonant inverters are commonly used. In such applications at least two inverters may be built on the same printed circuit board ("PCB") P, where usually the power switching devices D are THT type that are soldered to the PCB P and attached to a heat sink H through a screw S, as shown in FIG. 1. Usually, between the devices and the heatsink a thermal interface I is present to provide electrical insulation between the device D and the heat sink H, while maintaining a good thermal contact therebetween. Considering the operating powers and frequencies, the power switching devices are usually IGBTs in TO247 packages, as such devices are capable of handling currents up to 40A and voltages up to 1500V.

Due to their large package and the type of assembly, these devices remain expensive. Accordingly, it may be desired to replace them with other types of devices, with the objective to select components that may be less costly and easier to mount. Due to the power considerations discussed above, an inverter with a full-bridge arrangement may be able to incorporate switching devices of a different package type. In particular, operating with currents of the order of 20 A, it may make it possible to use power switching devices with devices packaged according to what is known as a D2PAK arrangement. Notably, a D2PAK package is a SMD-type device that is relatively smaller and less-costly than devices with a TO247-type package. Accordingly, D2PAK devices are becoming increasingly popular, gaining wide use in the automotive field, for example. Moreover, it may be possible to use D2PAK-type devices also with quasi resonant inverters or resonant half bridges, but with current limitations up to 20 A, resulting in low power delivery. In D2PAK packages it is possible to have different electronic components, such as diodes, silicon controlled rectifiers ("SCR"), IGBTs, MOSFETs, as well as components based on different semiconductors from the traditional silicon, such as SiC (silicon carbide) and GaN (gallium nitride). For example, due at least in part to the wide use of SiC devices in D2PAK in the automotive industry, this package type has reduced in cost and has been optimized also for better thermal performance for such applications. However, such packages may still require additional cooling or heat dissipation when used in the more demanding setting of an induction cooktop inverter. Notably, SMD packages, by nature, cannot be directly attached to a traditional heat sink, as the device D' is typically mounted directly, such as by soldering, on a copper pad A of the PCB P', as shown in FIG. 2.

In the automotive field, D2PAK packages have been used with SiC devices, which generate up to 50%-60% less heat than comparable traditional silicon devices. This allows the soldering of these devices directly on a large enough pad (usually copper with tin) for mounting with sufficient thermal dissipation. In other applications with similarly-low power usage, D2PAK devices can be soldered on a large pad with a heat sink placed on top of the devices, using a thermal interface between them. In this type of construction, the heat transfer occurs through the polymeric part of the package, which is not optimal but is generally sufficient for low-power applications. In applications where the power application is higher than the above examples, aluminum PCBs can be used instead of FR4, but such PCBs are much more expensive. Accordingly, further advances in the positioning SMD devices for dissipation of waste heat may be desired.

### SUMMARY OF THE DISCLOSURE

According to one aspect of the present disclosure, a printed circuit board for use in connection with at least one induction coil in an induction cooktop includes a substrate extending in first and second lateral directions between respective sides of a perimeter defined between first and second faces and a DC BUS having a high-side line and a low-side line for making available a DC voltage. At least one DC BUS capacitor is electrically connected to the DC BUS and is mounted on the first face of the substrate, and at least one resonant load capacitor is mounted on the first face of the substrate. The printed circuit board also includes at least one surface mount transistor mounted on the second face of the substrate and electrically connected with the DC bus capacitor and the resonant load capacitor through the printed circuit board. The printed circuit board is connectable with the at least one induction coil to define a resonant load with the resonant load capacitor.

According to another aspect of the present disclosure, a printed circuit board for use in connection with at least one induction coil in an induction cooktop includes a substrate extending in first and second lateral directions between respective sides of a perimeter defined between first and second faces. At least one pad is exposed on the second face of the substrate and is associated with a respective set of through-hole vias that extend through the substrate to the first face, and a DC BUS having a high-side line and a low-side line for making available a DC voltage. At least one DC bus capacitor is electrically connected to the DC BUS and is mounted on the first face of the substrate. At least one resonant load capacitor is mounted on the first face of the substrate. The printed circuit board further includes at least one surface mount transistor mounted on a respective one of the at least one pad so as to be disposed on the second face of substrate and being electrically connected with at least one of the DC bus capacitor and the resonant load capacitor through the printed circuit board.

According to yet another aspect of the present disclosure, an induction cooktop includes an induction coil and a printed circuit board. The printed circuit board has a substrate extending in first and second lateral directions between respective sides of a perimeter defined between first and second faces and a DC BUS having a high-side line and a low-side line for making available a DC voltage. At least one DC bus capacitor is electrically connected to the DC BUS and is mounted on the first face of the substrate. At least one resonant load capacitor is mounted on the first face of the substrate. The printed circuit board further has at least one surface mount transistor mounted on the second face of the substrate and electrically connected with the DC bus capacitor and the resonant load capacitor through the printed circuit board. The printed circuit board is connectable with the at least one induction coil to define a resonant load with the resonant load capacitor.

These and other features, advantages, and objects of the present disclosure will be further understood and appreciated by those skilled in the art by reference to the following specification, claims, and appended drawings.

### BRIEF DESCRIPTION OF THE DRAWINGS

In the drawings:
FIG. 1 is a perspective view of a related art through-hole technology transistor attached to a heat sink;
FIG. 2 is a perspective view of a related art surface mount device on a metal pad positioned on a printed circuit board;
FIG. 3 is a side schematic view of a surface mount device soldered on a through hole vias pad, according to an aspect of the disclosure;
FIG. 4 is a circuit diagram of a type of inverter that can be implemented according to an aspect of the disclosure;
FIG. 5 is a detail view of a through hole via included in the schematization of FIG. 3;
FIGS. 6A-6C are examples of a through hole via arrangements in respective pads to which a surface mount device is mounted.
FIG. 7 is a series of graphs including plots of the thermal resistance associated with the through hole via pads with variations in through hole via numbers and diameters;
FIG. 8 is a further graph including plots of the thermal resistance associated with the through hole via pads with further variations in through hole via inner diameters when the outer diameter is 0.6 mm;
FIG. 9 is a perspective view of a specific implementation of an inverter according to a further aspect of the disclosure;
FIG. 10 is a perspective view of another specific implementation of an inverter according to a further aspect of the disclosure; and
FIG. 11 is a perspective detailed view of a variation of the inverter of FIG. 10 including a temperature sensor.

The components in the figures are not necessarily to scale, emphasis instead being placed upon illustrating the principles described herein.

### DETAILED DESCRIPTION

The present illustrated embodiments reside primarily in combinations of method steps and apparatus components related to a printed circuit board for an induction cooktop. Accordingly, the apparatus components and method steps have been represented, where appropriate, by conventional symbols in the drawings, showing only those specific details that are pertinent to understanding the embodiments of the present disclosure so as not to obscure the disclosure with details that will be readily apparent to those of ordinary skill in the art having the benefit of the description herein. Further, like numerals in the description and drawings represent like elements.

For purposes of description herein, the terms "upper," "lower," "right," "left," "rear," "front," "vertical," "horizontal," and derivatives thereof shall relate to the disclosure as oriented in FIG. 1. Unless stated otherwise, the term "front" shall refer to the surface of the element closer to an intended viewer, and the term "rear" shall refer to the surface of the element further from the intended viewer. However, it is to be understood that the disclosure may assume various alternative orientations, except where expressly specified to the contrary. It is also to be understood that the specific devices and processes illustrated in the attached drawings, and described in the following specification are simply exemplary embodiments of the inventive concepts defined in the appended claims. Hence, specific dimensions and other physical characteristics relating to the embodiments disclosed herein are not to be considered as limiting, unless the claims expressly state otherwise.

The terms "including," "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus. An element preceded by "comprises a . . . " does not, without more constraints, preclude the existence of additional identical elements in the process, method, article, or apparatus that comprises the element.

Ordinal modifiers (i.e., "first", "second", etc.) may be used to distinguish between various structures of a disclosed article in various contexts, but such ordinals are not necessarily intended to apply to such elements outside of the particular context in which they are used and that, in various aspects different ones of the same class of elements may be identified with the same, context-specific ordinal. In such instances, other particular designations of the elements are used to clarify the overall relationship between such elements. Ordinals are not used to designate a position of the elements, nor do they exclude additional, or intervening, non-ordered elements or signify an importance or rank of the elements within a particular class.

For purposes of this disclosure, the term "coupled" (in all of its forms, couple, coupling, coupled, etc.) generally means the joining of two components (electrical or mechanical) directly or indirectly to one another. Such joining may be stationary in nature or movable in nature. Such joining may be achieved with the two components (electrical or mechanical) and any additional intermediate members being integrally formed as a single unitary body with one another or with the two components. Such joining may be permanent in nature or may be removable or releasable in nature unless otherwise stated.

For purposes of this disclosure, the terms "about", "approximately", or "substantially" are intended to mean that a value of a parameter is close to a stated value or position. However, minor differences may prevent the values or positions from being exactly as stated. Thus, unless otherwise noted, differences of up to ten percent (10%) for a given value are reasonable differences from the ideal goal of exactly as described. In many instances, a significant difference can be when the difference is greater than ten percent (10%), except as where would be generally understood otherwise by a person of ordinary skill in the art based on the context in which such term is used.

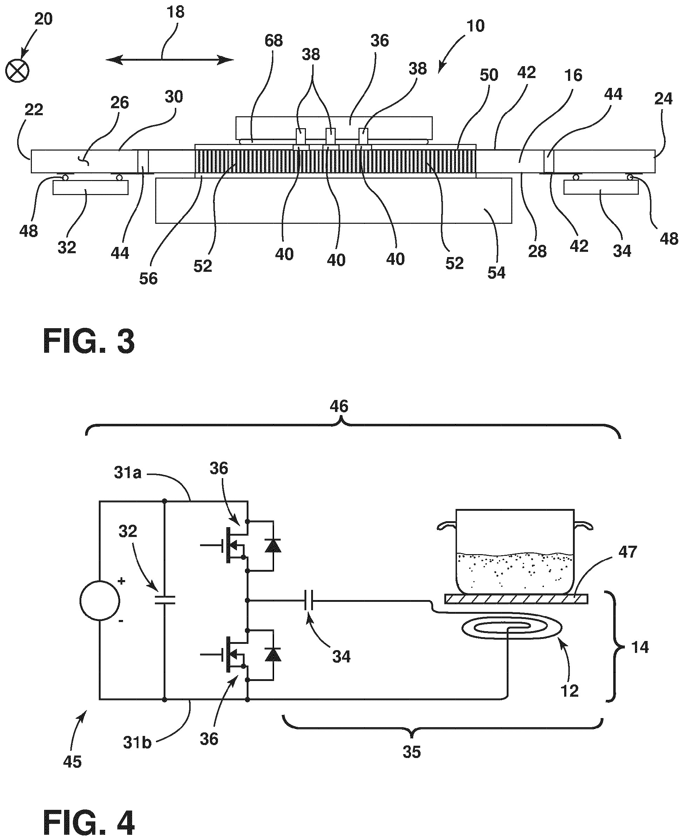

Referring to FIGS. 3-11, reference numeral 10 generally designates a printed circuit board for use in connection with at least one induction coil 12 in an induction cooktop 14. The printed circuit board 10 includes a substrate 16 extending in first and second lateral directions 18, 20 between respective sides 22, 24 of a perimeter 26 defined between first and second faces 28, 30 and a DC BUS 31 having a high-side line 31a and a low-side line 31b for making available a DC voltage. At least one capacitor 32 is electrically connected to the DC BUS 31 and is mounted on the first face 28 of the substrate 16. As discussed herein, the capacitor 32 that is electrically connected to the DC BUS 31 is referred to as the "DC BUS capacitor" 32. At least one additional capacitor 34 is mounted on the first face 28 of the substrate and forms one component of a resonant load 35 along with the induction coil 12. In this manner, the capacitor 34 within the resonant load 35 is referred to herein as the "resonant load capacitor" 34. The at least one DC BUS capacitor 32 and the at least one resonant load capacitor 34 are spaced apart in at least the first lateral 18 direction toward respective opposite sides 22, 24 of the perimeter 26 of the substrate 16. The printed circuit board 10 also includes at least one surface mount transistor 36 mounted on the second face 30 of the substrate 16 and positioned between the at least one DC BUS capacitor 32 and the at least one resonant load capacitor 34 with respect to the first lateral direction 18. The at least one surface mount transistor 36 is electrically connected with the DC BUS capacitor 32 and the resonant load capacitor 34 through the substrate 16. The printed circuit board is connectable with the at least one induction coil 12 to define a resonant load 35 with the resonant load capacitor 34 (FIG 4).

An example schematic of this arrangement is shown in FIG. 3, in which the surface mount transistor 36 has terminals 38 that are connected to conductive pads 40 that are integrated with traces 42 on the second face 30 of the substrate 16. The traces 42 are coupled with conductive vias 44 that extend through the substrate 16 to the first face 28 and connect with additional traces 42 that connect with the DC BUS capacitor 32 and the resonant load capacitor 34. In this respect, it is to be noted that the arrangement shown is illustrative of one example of the relative positioning of the electronic components discussed above and that additional components may be added, depending on the particular configuration of the PCB 10, of which several are generally known and can be adapted to the principles of the present disclosure. Additionally, the description herein of the surface mount transistor 36 as being electrically connected with at least one DC BUS capacitor 32 and the resonant load capacitor 34 does not necessarily mean that the components are directly connected or are connected by an arrangement as directly shown in FIG. 3.

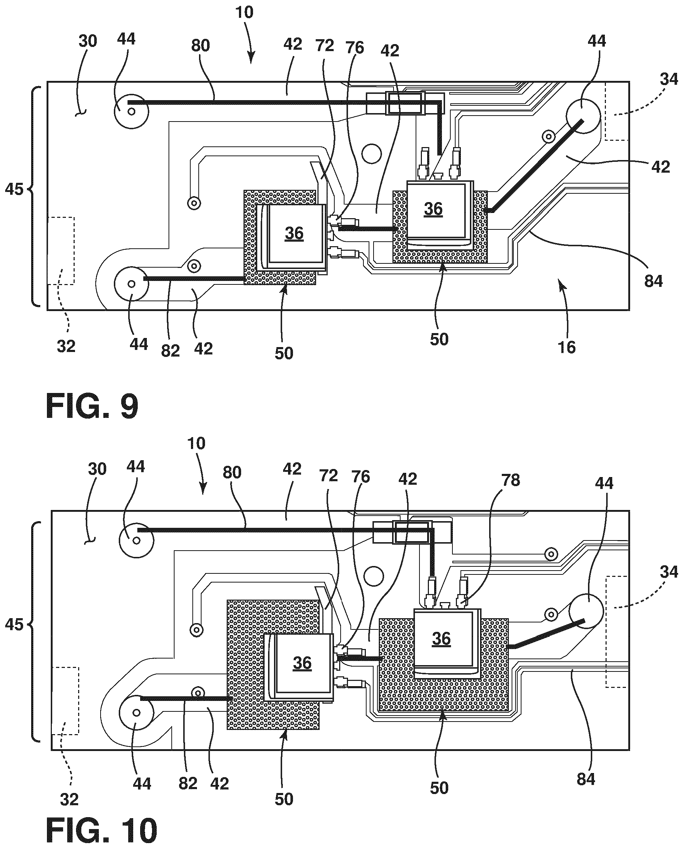

Figure 4 shows a possible implementation of a half-bridge resonant inverter 45, and it is to be appreciated that this circuit is an example of one of several possible implementations of an inverter 45 that can be in the structure of PCB 10 according to the present disclosure. In the present example, the inverter 45 is used to provide a current to resonant load 35, which includes the resonant load capacitor 34 and the induction coil 12 discussed above. In various additional examples, the inverter 45 can be associated with multiple resonant loads 35. In still further examples, the PCB 10 can include multiple inverters 45 associated with various respective resonant loads 35 (i.e., in a configuration of an induction cooktop 14 with multiple coils 12 beneath a single cooktop glass 47). It is to be appreciated that further examples of PCB 10 can include additional circuits associated with the operation of the associated induction cooktop 14. In at least the present example, the surface mount transistor 36 is configured as a power switching device 36 associated with the inverter 45. In this and other examples, the at least one surface mount transistor 36 includes two power switching devices 36. In the additional examples of FIGS. 9-11, both surface mount transistors 36 are mounted on the second face 30 of the substrate 16 and both being positioned between the DC BUS capacitor 32 and the resonant load capacitor 34 with respect to the first lateral direction 18 (as shown in FIGS. 9 and 10, discussed further below). The two power switching devices 36 are both electrically connected with the DC BUS capacitor 32 and the resonant load capacitor 34 through the substrate 16. In various examples, the PCB 10 can have multiple inverters 45.

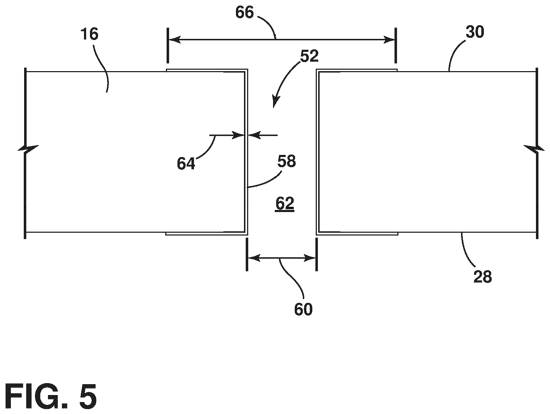

Returning to FIG. 3, the at least one surface mount transistor 36 can be soldered onto the second face 30 of the substrate 16, such as by an extended solder joint 48. More specifically, the at least one surface mount transistor 36 can be soldered onto a respective one of at least one pad 50 exposed on the second face 30, the at least one pad 50 being associated with a respective set of through-hole vias 52 that extend through the substrate 16 to the first face 28. The through-hole vias 52 are utilized, according to an aspect of the disclosure, to thermally connect the surface mount transistor 36 with a heat sink 54 mounted on the first face 28 of the substrate 16 and generally aligned with the surface mount transistor 36. As further shown, a thermal interface 56 is positioned between the through-hole vias 52 and the heat sink 54. The thermal interface 56 is a material configured to provide conduction of thermal energy therethrough, while remaining electrically isolating. In this manner, the through-hole vias 52 can be coated with a material that is conductive of both electrical and thermal energy, such as copper or tin, typically used in this application. The thermal interface 56 can be used to allow the conduction of heat from the conductive material of the through-hole vias 52 to the heat sink 54, while maintaining electrical insulation therebetween. According to this construction, waste heat from the surface mount transistor 36 mounted over the through-hole vias 52 is conducted through the vias by way of at least the coating 58 (see FIG. 5) applied to the through-hole vias 52, through the substrate 16, and into the heat sink 54 for ambient dissipation thereof. This arrangement can be further configured to maintain improved heat management, as discussed further below. As discussed further below, the through-hole vias 52 can include a coating 58 comprising a thermally and electrically conductive material. The thermally and electrically conductive material can be copper, tin, or a mixture of copper and tin. The coating 58 can define a thickness 64 between 15 µm and 20 µm.

As discussed above, surface mount devices of the type used herein for the above-described surface mount transistors 36 are typically soldered onto a PCB on the "back" side thereof, which can include an exposed pad (see FIG. 2). Notably, in such a mounting arrangement, it is not possible to attach a heatsink in a typical manner (i.e., on the back of the surface mount device). As the power consumption of an inverter of the type described herein and used, as described above, in an induction cooktop, the present arrangement provides a structure to dissipate heat from the surface mount transistor 36, or transistors 36 in an efficient package using generally existing materials. In particular, the substrate 16 can be a generally common FR4 substrate but can be configured including a large number of through-hole vias 52, with the surface mount transistor 36 soldered to the substrate 16 on the designated second face 30 of the substrate 16. As discussed, this arrangement allows for attachment of the heat sink 54 on the first face 28 the substrate 16. The through-hole vias 52 are conductive holes that typically connect the traces 42 of different layers of a PCB defined by the associate substrate or substrates. Being usually composed of (or coated with) copper, the through-hole vias 52 also have thermal conduction properties that can provide thermal contact between the two layers (or sides 28 and 30) of the substrate 16.

The present arrangement utilizes these properties to thermally connect the surface mount transistor 36 with the heat sink 54. The thermal contact provided by each via is generally weak (i.e., the corresponding thermal resistance is large). By incorporating a large number of through-hole vias 52, the thermal contact between the first face 28 and the second face 30 may be improved by reducing the total corresponding thermal resistance. As particularly shown in FIG. 5, the through-hole vias 52 have an inner diameter 60 that generally corresponds with the size of the hole 62 formed in the substrate 16 (minus the thickness 64 of the coating 58), along with an outer diameter 66 defined by the extension of the coating 58 along the respective faces 28, 30 of the substrate 16. In the present arrangement, the close positioning of a large number of through-hole vias 52 can aggregate the coating 58 portions defined between the inner diameters 60 and the outer diameters 66 to, in one example, collectively define the pad 50 on each side 28, 30 of the substrate 16. Pad 50 can additionally be formed by depositing copper (similar to the material of the coating 58) in the area between the vias (i.e. in the zones of the PCB not actually covered by the outer diameter 66, as packing circles may not cover the entire surface in the area of the pad). The incorporation of the above described thermal interface 56 between the pad 50 on the first face 28 and the heat sink 54 allows the power switching devices (surface mount transistor 36) to be soldered directly to the pad on the second face 30, which may be done with a single pass of solder to connect any additional surface mount transistors 36 on the second side 24 of the PCB in a single assembly step, reducing the long assembly times associated with the use of THT devices. Figure 3 shows a close-up section view of surface mount transistor 36 on the substrate 16 over the related pad 50 (as connected by a solder mass 68) and thermally connected with the heat sink 54, as generally described above. The use of thermal interface 56 can also allow for the use of a single heat sink 54 to be connected with multiple pads 50 being respectively associated with a surface mount transistor 36.

To provide a desired level of thermal transfer between the two sides 28, 30 of the substrate 16, the density of the through-hole vias 52 (i.e., the number of through-hole vias 52 per unit area), the through hole via 52 size and characteristics (i.e., the inner and outer diameter 60, 66, and the coating thickness 64 and materials) are considered. At the same time, it is desired to maintain the creepage and clearance distances of the pads 50 and traces 42 associated with the surface mount transistors 36 (FIGS. 3, 11, and 12) as a function of the working voltages of the inverter 45. Referring again to FIG. 5 the geometry of the through-hole vias 52 is shown, including the inner and outer diameters 60, 66. One measure of the effectiveness of the heat dissipation of the present arrangement is the calculation of the thermal resistance through the substrate 16, which may be measured in Kelvin per Watt ("K/W"), is a quantification of how difficult it is for heat to be conducted through a material. The lower the thermal resistance through the through-hole vias 52 in the associated pad 50, the more heat will be transferred from the surface mount transistor 36 to the heat sink 54. In one aspect, the above-described characteristics of the through-hole vias 52 are adjusted to achieve an appropriate compromise between the size of the vias (internal diameter 60 versus external diameter 66), the number of through-hole vias 52 in a given pad 50, and the spacing of the through-hole vias 52 in the pad 50.

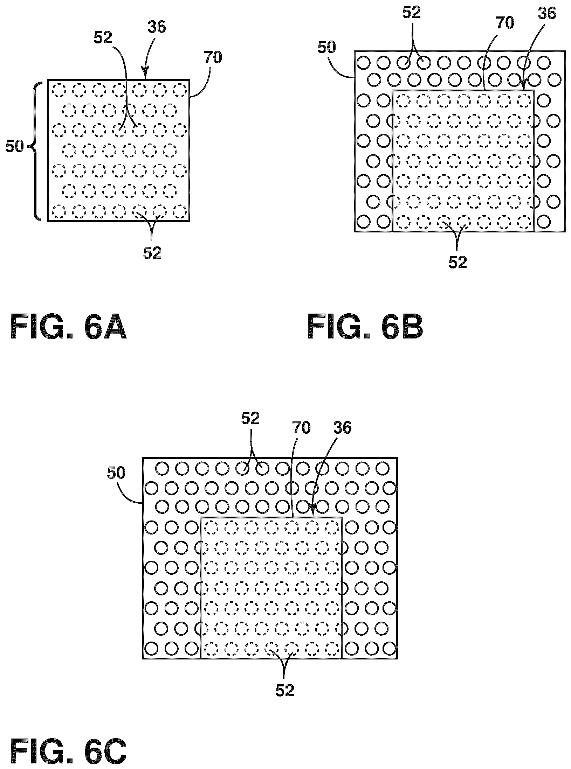

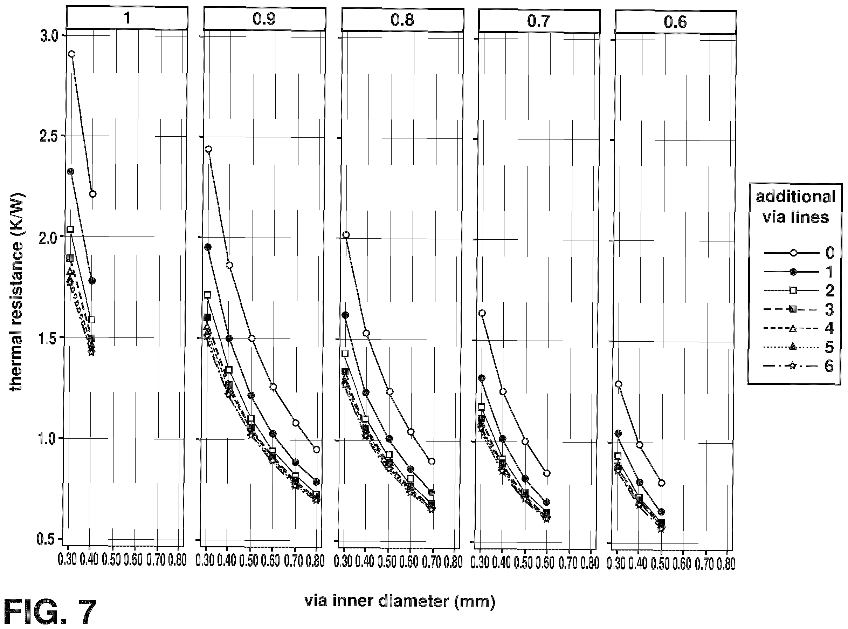

In some aspects, the minimum inside and outside diameters 60, 66, in various combinations, depend on the PCB 10 manufacturer. Similarly, the material inside the through-hole vias 52 commonly comprises copper at a thickness that may be generally standard within the industry and may be about 18 µm to 20 µm. Considering the various combinations of inner and outer diameters 60, 66 most commonly produced, it has been found that the more through-hole vias 52 there are in a given pad 50, the better the thermal conduction through the substrate 16 in the area of the pad 50. Accordingly, the distance between the through-hole vias 52 in a given pad 50 may be fixed at 0.2 mm, which in some aspects may be the minimum value guaranteed by most PCB manufacturers. Given the fixed spacing of the through-hole vias 52, different possible combinations of via dimensions that can fill at least the area under the respective surface mount transistor 36 (e.g., a D2PAK package of about 100 mm²) as shown in FIG. 6A, can be considered. It has been determined that, in such an arrangement, the equivalent value of the thermal resistance may range from 2.4 K/W, at a high end (for through-hole vias 52 having a 0.3 mm inner diameter 60 and a 0.9 mm outer diameter 66) up to about 0.8 K/W at a low end, noting again that a lower thermal resistance is preferred, (for through-hole vias 52 having a 0.5 mm inner diameter 60 and 0.6 mm outer diameter). As shown in the graphs of FIG. 7, it has been found that the lowest thermal resistance in the present arrangement is obtained by increasing the inner diameter 60 of the through-hole vias 52 (which provides more cross-sectional area for heat flow through the medium within the through-hole vias 52, which may be air or solder), and decreasing the outer diameter 66 of the through-hole vias 52 (with each of the plots in FIG. 7 corresponding with a different outer diameter 66, as indicated above each such plot). It can be appreciated that this configuration results in a greater density of the through-hole vias 52, which increases the density and, therefore, the total number of through-hole vias 52 under the area of the exposed pad 50 on the substrate 16.

As further shown in FIG. 7, the thermal resistance associated with a given pad 50 can be further lowered by adding through-hole vias 52 around the perimeter 70 of the surface mount transistor 36, thereby increasing the size of the pad 50 to larger than the surface mount transistor 36. The general effect of adding more lines (rows and columns) of through-hole vias 52 to the pad 50, around the surface mount transistor 36, for example one line above and two lateral, two above and four lateral (two at left and two on the right) and so on (as illustrated in FIG. 6B and 6C), is shown in FIG. 7 and helps to find an acceptable compromise between resistance values and occupied space.

More specifically, the graphs of FIG. 7 show the value of the equivalent thermal resistance of the pad 50 formed by the through-hole vias 52 as a function of their diameters (inside 60 and outside 66) and their number (at the given 0.2 mm spacing). As can be seen, the thermal resistance decreases as the outer diameter 66 decreases and the inner diameter 60 increases. Furthermore, the various lines indicate the resulting thermal resistance as the number of vias varies. In particular, one line (according to the symbolic indication on the line in correspondence with the provided key) indicates the thermal resistance of a pad 50 of through-hole vias 52 that extends beneath only the area of the corresponding surface mount transistor 36), while the other lines indicate the equivalent value of thermal resistance as the number of through-hole vias 52 (and, accordingly, the pad 50 size) increases.

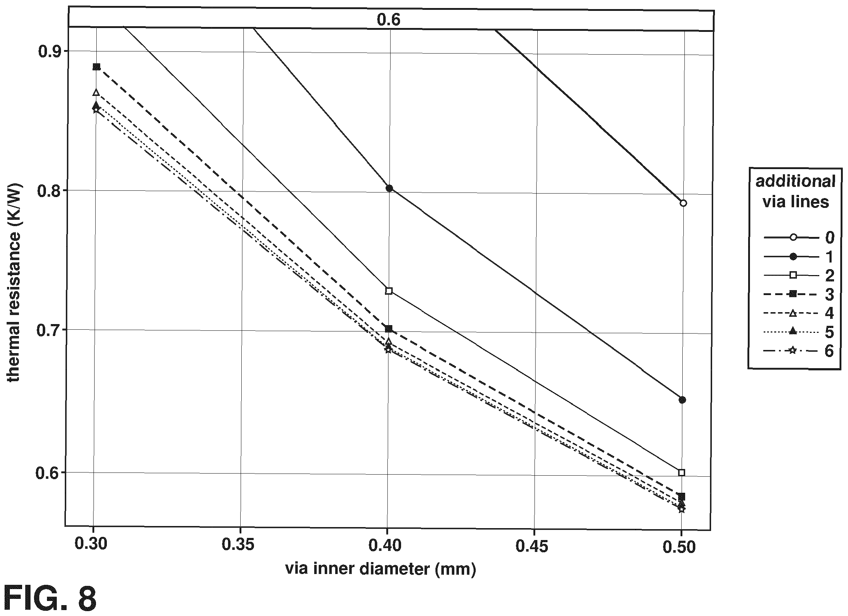

In particular, a number of lines equal to three above and six lateral (as shown in FIG. 6C), which may be equivalent to about a total area of about 180 mm² for the pad 50 (including the area below and outside of the surface mounted transistor 36), provides acceptable thermal resistance in an acceptable total area. Figure 8 includes a graph that shows the value of the equivalent thermal resistance of the pad 50 formed by through-hole vias 52 with an outer diameter 66 of 0.6 mm and inner diameter 60 of various values between 0.30 and 0.50. The various lines indicate the various results as the number of through-hole vias 52 varies (as indicated by the symbols on the lines indicated in the corresponding key). As shown, an acceptable compromise between thermal resistance value and number of through-hole vias 52, again, corresponds with a configuration with three lines "above" the surface mount transistor 36 and six lines lateral thereof (as shown in the example of FIG. 6C). As can be seen from the graph in FIG. 8 (which shows the varying thermal resistances corresponding with additional via lines and varying inner diameters 60 with an outer diameter 62 of 0.6 mm, as indicated above the plot), in this configuration a thermal resistance of about 0.58 K/W is realized. Further increasing the number of vias may not lead to a significant decrease in resistance and may unnecessarily take up space on the substrate 16. To maximize the density, the through-hole vias are positioned in a honeycomb pattern, as shown in FIG. 6C. As further shown in FIG. 6C (and in the specific examples of FIGS. 9- 11), no lines of through-hole vias 52 are added to the side of the surface mount transistor 36 on which the terminal 38 are present, because (as shown in FIGS. 9-11) it may be desired to define a gap 72 in the substrate 16 to accommodate desired insulation distances (clearance and creepage), as described further below.

While the graphs in FIGS. 7 and 8 show a configuration that has been determined to provide acceptable spacing and thermal conductivity, other acceptable implementations of the present structure can be realized with other dimensions. In one example, each of the through-hole vias 52 can have an inner diameter 60 of between 0.4 mm and 0.5 mm and an outer diameter 66 of between 0.8 mm and 0.6 mm. In various examples, the through-hole vias 52 can be spaced from each other at a distance of between 0.3 mm and 0.2 mm and can be arranged in a honeycomb pattern, as discussed above. In various examples, the pads 50 can each have between 50 and 5000 through-hole vias 52 and, more particularly between 320 and 350 through-hole vias.

It is again noted that the vias, in one arrangement, can all be connected to each other with a single copper plane (i.e., pad 50) resulting from the relative spacing and outer diameters 60 of the various through-hole vias 52 and the addition of conductive material between the outer diameters 60. This arrangement can further improve the thermal contact between the surface mount transistor 36 and the through-hole vias 52. The thermal conductivity may be further improved by filling the through-hole vias 52. In this aspect, when the surface mount transistor 36 is soldered to the pad 50, the through-hole vias 52 may at least partially filled with tin, which to further decreases the thermal resistance of the associated through-hole vias 52 due to the thermal conductivity provided by the tin of the solder.

As discussed above, variations of the inverter 45 that include multiple surface mounted transistors 36, including in connection with half-bridge inverter arrangements using two power switching devices, as shown in the schematic of FIG. 4. In such variations, the surface mounted transistors 36 can be mounted on respective pads 50 according to the implementations discussed above. Additionally, the PCB 10 can further include multiple heat sinks 54 mounted on the first face 28 of the substrate 16 in respective positions aligned with the pads 50 and thermally coupled therewith by a corresponding thermal interface 56, with the thermal interfaces 56 electrically isolating the heat sinks 54 from the through-hole vias 52. FIG. 9 shows one possible implementation of a PCB 10 including a half bridge inverter 45 using D2PAK devices for the surface mounted transistors 36, with the same being mounted on pads 50 defined by a corresponding set of through-hole vias 52 thermal contact with corresponding heat sinks 54 on the first side 28 of the substrate 16. More specifically, the arrangement shown in FIG. 9 includes two pads 50 according to the example shown in FIG. 6C and discussed further above. Further, the inverter 45 is a resonant half bridge inverter, with the DC bus capacitor 32 disposed on the first face 28 toward the first side 22 of the substrate 16 and the resonant load capacitor 34, along with connector terminals to couple the inverter 45 with a coil 12 of the cooktop 14, disposed on the first face 28 toward the second side 24 of the substrate 16. As discussed above, the power switching devices realized by the surface mount transistors 36 are positioned on the second face 30 between the locations of the DC bus capacitor 32 and the resonant load capacitor 34. To minimize the length of the traces 42 utilized in connection with this arrangement, especially between the emitter 76 of one power switching device 36 and the collector (which corresponds with the back side of the device and is soldered on the pad 50) of the other power switching device 36, the left-side device 36 has been rotated 90 degrees relative to the other device 36. Furthermore, gaps 72 are present in effective locations for maintaining the insulation distance for clearance and creepage on the PCB and, particularly, of the surface mount transistors 36. The traces associated with the DC bus capacitor 32 (positive VBUS and ground) are overlapped toward the first side 22 to minimize parasitic components and interference.

With respect to the surface mount transistors 36, the traces 42 of the ground 80 and of the VBUS 82 originating from the terminals 44 of the DC bus capacitor 32 branch off toward the second side 24 and connect the surface mount transistors 36. The signal traces of the gate driver 84 are parallel to each other following a minimum possible path, so as to limit any parasitic inductances. For purposes of electrical insulation, it may be desired to include all traces 42 associated with power and signal transmission of the inverter 45 on the second face 30, along with the power switching devices 36. This prevents the need to use a single insulating thermal interface, as large as the heat sink 54, which would lead to an increase in cost. For these reasons, it may be desired to derive a compromise between the space occupied by the pads 50 and the power and signal traces 42 of the PCB 10. In the present examples, the inverters 45 are arranged with the pads 50 and the power and signal traces 42 positioned so as to provide desired thermal dissipation of the surface mount transistor 36 heat, while maintaining an appropriate clearance and creepage distance. Figure 10 shows another implementation of pad 50 that includes six lines of through-hole vias 52 opposite the terminals 38 and twelve lateral. As seen in the graph of FIG. 7, the two implementations may be found to have a comparable thermal resistance.

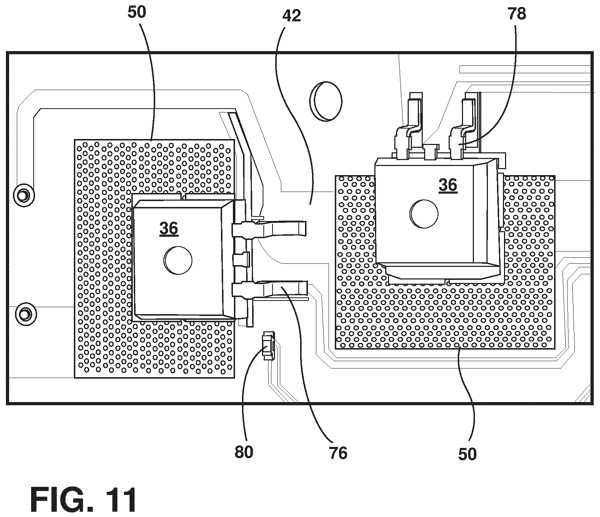

In another aspect, temperature measurement of the surface mount transistors 36 is considered. Typically, in connection with THT devices, the temperature may be estimated by measuring the temperature of the associated heatsink, with a Negative Temperature Coefficient ("NTC") thermistor attached to the heat sink. In a further variation of the present PCB 10, shown in FIG. 11, with SMD devices, a SMD-type NTC 86 is positioned between the two surface mount transistors 36, near the pads 50, while maintaining an appropriate isolation distance. This arrangement can provide an estimate for the temperature of both surface mounted transistors 36.

The invention disclosed herein is further summarized in the following paragraphs and is further characterized by combinations of any and all of the various aspects described therein.

According to another aspect of the present disclosure, a printed circuit board for use in connection with at least one induction coil in an induction cooktop includes a substrate extending in first and second lateral directions between respective sides of a perimeter defined between first and second faces and a DC BUS having a high-side line and a low-side line for making available a DC voltage. At least one DC bus capacitor is electrically connected to the DC BUS and is mounted on the first face of the substrate, and at least one resonant load capacitor is mounted on the first face of the substrate. The printed circuit board also includes at least one surface mount transistor mounted on the second face of the substrate and electrically connected with the DC bus capacitor and the resonant load capacitor through the printed circuit board. The printed circuit board is connectable with the at least one induction coil to define a resonant load with the resonant load capacitor.

In the printed circuit board of ¶ [0046], the surface mount transistor can be configured as a power switching device.

In the printed circuit board of ¶ [0047], the at least one surface mount transistor can include two power switching devices, both being mounted on the second face of the printed circuit board and both being positioned between the at least one capacitor electrically connected to the DC BUS and the at least one resonant load capacitor, with respect to the first lateral direction, the two power switching devices can be electrically connected with the at least one capacitor electrically connected to the DC BUS and the at least one capacitor of the resonant load through the printed circuit board.

In the printed circuit board of any of ¶¶ [0046] to [0048], the at least one DC BUS capacitor and the at least one resonant load capacitor can be spaced apart in at least the first lateral direction toward respective opposite sides of the perimeter, and the at least one surface mount transistor can be positioned between the at least one DC bus capacitor and the at least one resonant load capacitor with respect to the first lateral direction.

In the printed circuit board of any of ¶¶ [0046] to [0049], the at least one surface mount transistor can be soldered onto the second face of the substrate.

In the printed circuit board of ¶ [0050], the at least one surface mount transistor can be soldered onto a respective one of at least one pad exposed on the second face, the at least one pad being associated with a respective set of through-hole vias that extend through the substrate to the first face.

In the printed circuit board of ¶ [0051], each of the through-hole vias in the respective pads can have an inner diameter of between 0.4 mm and 0.5 mm and outer diameter of between 0.8 mm and 0.6 mm.

In the printed circuit board of ¶¶ [0051] or [0052], the through-hole vias associated with the respective pads can be spaced from each other at a distance of between 0.3 mm and 0.2 mm and are arranged in a honeycomb pattern.

In the printed circuit board of any of ¶¶ [0051] to [0053], the pads can each have between 50 and 5000 through hole vias.

In the printed circuit board of any of ¶¶ [0051] to [0054], wherein the pads each have between 320 and 350 through hole vias.

In the printed circuit board of any of ¶¶ [0051] to [0055], the through-hole vias can include a coating comprising a thermally and electrically conductive material.

In the printed circuit board of ¶ [0056], the thermally and electrically conductive material can be copper.

In the printed circuit board of ¶¶ [0056] or [0057], wherein the coating defines a thickness between 15 µm and 20 µm.

The printed circuit board of ¶ [0050] can further include at least one heat sink mounted on the first face of the printed circuit board in a position aligned with at least one of the pads and thermally coupled therewith by a thermal interface, the thermal interface electrically isolating the heat sink from the through hole vias.

According to another aspect of the disclosure, a printed circuit board for use in connection with at least one induction coil in an induction cooktop includes a substrate extending in first and second lateral directions between respective sides of a perimeter defined between first and second faces, at least one pad exposed on the second face of the substrate and being associated with a respective set of through-hole vias that extend through the substrate to the first face, and a DC BUS having a high-side line and a low-side line for making available a DC voltage. At least one DC bus capacitor is electrically connected to the DC BUS and is mounted on the first face of the substrate. At least one resonant load capacitor is mounted on the first face of the substrate. The printed circuit board further includes at least one surface mount transistor mounted on a respective one of the at least one pad so as to be disposed on the second face of substrate and being electrically connected with at least one of the DC bus capacitor and the resonant load capacitor through the printed circuit board.

The printed circuit board of ¶ [0060] can further including at least one heat sink mounted on the first face of the printed circuit board in a position aligned with at least one of the pads and thermally coupled therewith by a thermal interface, the thermal interface electrically isolating the heat sink from the through hole vias, and the at least one surface mount transistor can be soldered onto the respective one of the at least one pad.

In the printed circuit board of ¶¶ [0060] or [0061], each of the through-hole vias in the respective pads can have an inner diameter of between 0.4 mm and 0.5 mm and outer diameter of between 0.8 mm and 0.6 mm.

In the printed circuit board of any of ¶¶ [0060] to [0062], the through-hole vias associated with the respective pads can be spaced from each other at a distance of between 0.3 mm and 0.2 mm and are arranged in a honeycomb pattern, and the pads can each have between 50 and 5000 through-hole vias associated therewith.

In the printed circuit board of any of ¶¶ [0060] to [0063], the through-hole vias can include a coating comprising copper and defining a thickness between 15 µm and 20 µm.

In the printed circuit board of any of ¶¶ [0060] to [0064], the DC bus capacitor and the resonant load capacitor can be spaced apart in at least the first lateral direction toward respective opposite sides of the perimeter, and the surface mount transistor can be positioned between the DC BUS and the resonant load capacitor with respect to the first lateral direction.

According to another aspect of the disclosure, an induction cooktop includes an induction coil and a printed circuit board. The printed circuit board has a substrate extending in first and second lateral directions between respective sides of a perimeter defined between first and second faces and a DC BUS having a high-side line and a low-side line for making available a DC voltage. At least one DC bus capacitor is electrically connected to the DC BUS and is mounted on the first face of the substrate. At least one resonant load capacitor is mounted on the first face of the substrate. The at least one DC BUS capacitor and the at least one resonant load capacitor are spaced apart in at least the first lateral direction toward respective opposite sides of the perimeter. The printed circuit board further has at least one surface mount transistor mounted on the second face of the substrate and positioned between the at least one DC bus capacitor and the at least one resonant load capacitor with respect to the first lateral direction. The at least one surface mount transistor is electrically connected with the DC bus capacitor and the resonant load capacitor through the printed circuit board. The printed circuit board is connectable with the at least one induction coil to define a resonant load with the resonant load capacitor.

It will be understood by one having ordinary skill in the art that construction of the described disclosure and other components is not limited to any specific material. Other exemplary embodiments of the disclosure disclosed herein may be formed from a wide variety of materials, unless described otherwise herein.

It is also important to note that the construction and arrangement of the elements of the disclosure as shown in the exemplary embodiments is illustrative only. Although only a few embodiments of the present innovations have been described in detail in this disclosure, those skilled in the art who review this disclosure will readily appreciate that many modifications are possible (e.g., variations in sizes, dimensions, structures, shapes and proportions of the various elements, values of parameters, mounting arrangements, use of materials, colors, orientations, etc.) without materially departing from the novel teachings and advantages of the subject matter recited. For example, elements shown as integrally formed may be constructed of multiple parts or elements shown as multiple parts may be integrally formed, the operation of the interfaces may be reversed or otherwise varied, the length or width of the structures and/or members or connector or other elements of the system may be varied, the nature or number of adjustment positions provided between the elements may be varied. It should be noted that the elements and/or assemblies of the system may be constructed from any of a wide variety of materials that provide sufficient strength or durability, in any of a wide variety of colors, textures, and combinations. Accordingly, all such modifications are intended to be included within the scope of the present innovations. Other substitutions, modifications, changes, and omissions may be made in the design, operating conditions, and arrangement of the desired and other exemplary embodiments without departing from the spirit of the present innovations.

It will be understood that any described processes or steps within described processes may be combined with other disclosed processes or steps to form structures within the scope of the present disclosure. The exemplary structures and processes disclosed herein are for illustrative purposes and are not to be construed as limiting.

## Claims

1. A printed circuit board (10) for use in connection with at least one induction coil (12) in an induction cooktop (14), the printed circuit board (10) comprising:
a substrate (16) extending in first and second lateral directions (18, 20) between respective sides (22, 24) of a perimeter (26) defined between first and second faces (28, 30);
a DC BUS (31) having a high-side line (31a) and a low-side line (31b) for making available a DC voltage, wherein at least one DC BUS capacitor (32) is electrically connected to the DC BUS (31) and is mounted on the first face (28) of the substrate (16);
at least one resonant load capacitor (34) mounted on the first face (28) of the substrate (16); and
at least one surface mount transistor (36) mounted on the second face (30) of the substrate (16) and being electrically connected with the DC BUS capacitor (32) and the resonant load capacitor (34) through the substrate (16);
wherein the printed circuit board (10) is connectable with the at least one induction coil (12) to define a resonant load (35) with the resonant load capacitor (34).

2. The printed circuit board (10) of claim 1, wherein:
the at least one DC BUS capacitor (32) and the at least one resonant load capacitor (34) are spaced apart in at least the first lateral direction (18) toward respective opposite sides (22, 24) of the perimeter (26); and
the at least one surface mount transistor (36) is positioned between the at least one DC BUS capacitor (32) and the at least one resonant load capacitor (34) with respect to the first lateral direction (18).

3. The printed circuit board (10) of claim 2, wherein the surface mount transistor (36) is configured as a power switching device (36).

4. The printed circuit board (10) of any one of claims 1 to 3, wherein the at least one surface mount transistor (36) includes two power switching devices (36), both being mounted on the second face (30) of the substrate (16) and both being positioned between the at least one DC BUS capacitor (32) and the at least one resonant load capacitor (34), with respect to the first lateral direction (18), the two power switching devices (36) being electrically connected with the at least one DC BUS capacitor (32) electrically connected to the DC BUS (31) and the at least one capacitor (34) of the resonant load (35), through the substrate (16).

5. The printed circuit board (10) of any one of claims 1 to 4, wherein the at least one surface mount transistor (36) is soldered onto a respective one of at least one pad (50) exposed on the second face (30) of the substrate (16), the at least one pad (50) being associated with a respective set of through-hole vias (52) that extend through the substrate (16) to the first face (28).

6. The printed circuit board (10) of claim 5, wherein each of the through-hole vias (52) in the respective pads (50) has an inner diameter (60) of between 0.4 mm and 0.5 mm and outer diameter (66) of between 0.8 mm and 0.6 mm.

7. The printed circuit board (10) of either claim 5 or claim 6, wherein the through-hole vias (52) associated with the respective pads (50) are spaced from each other at a distance of between 0.3 mm and 0.2 mm and are arranged in a honeycomb pattern.

8. The printed circuit board (10) of claim 7, wherein the pads (50) each have between 50 and 5000 through hole vias (52).

9. The printed circuit board (10) of claim 7, wherein the pads (50) each have between 320 and 350 through hole vias (52).

10. The printed circuit board (10) of any one of claims 5 to 9, wherein the through-hole vias (52) include a coating (58) comprising a thermally and electrically conductive material.

11. The printed circuit board (10) of claim 10, wherein the thermally and electrically conductive material is copper.

12. The printed circuit board (10) of claim 11, wherein the coating (58) defines a thickness (64) between 15 µm and 20 µm.

13. The printed circuit board (10) of any one of claims 5 to 12, further including at least one heat sink (54) mounted on the first face (28) of the substrate (16) in a position aligned with at least one of the pads (50) and thermally coupled therewith by a thermal interface (56), the thermal interface (56) electrically isolating the heat sink (54) from the through hole vias (52).

14. An induction cooktop (14), comprising:
an induction coil (12); and
a printed circuit board (10) according to any of the preceding claims;
wherein the printed circuit board (10) is connectable with the at least one induction coil (12) to define a resonant load (35) with the resonant load capacitor (34).
